# EUROPEAN PATENT APPLICATION

(11) **EP 4 626 176 A2**
(43) Date of publication of application: **01.10.2025**
(21) Application number: 25156377.1
(22) Date of filing: 06.02.2025
(51) Int. Cl.: H10D 84/01, H10D 30/01, H10D 30/43, H10D 30/00, H10D 84/03, H10D 84/85

(54) **DIELECTRIC WALL USED TO SEPARATE GATE DIELECTRIC BETWEEN ADJACENT DEVICES**

(30) Priority: 29.03.2024 US 202418621806
(71) Applicant: INTEL Corporation, Santa Clara, CA 95054 (US)
(72) Inventor: ZHANG, Yang, Rio Rancho, NM 87124 (US); XU, Guowei, Portland, OR 97229 (US); CHU, Tao, Portland, OR 97229 (US); CHAO, Robin, Portland, OR 97209 (US); ZHANG, Feng, Portland, OR 97229 (US); HUNG, Ting-Hsiang, Beaverton, OR 97007 (US); LIN, Chia-Ching, Portland, OR 97229 (US); ZHANG, Kan, Hillsboro, OR 97123 (US); YEUNG, Chun Wing, Portland, OR 97229 (US); LIN, Chung-Hsun, Portland, OR 97229 (US); MURTHY, Anand, Portland, OR 97229 (US)
(74) Representative: HGF

(57) **Abstract**

Techniques are provided herein to form semiconductor devices that include a dielectric wall between adjacent semiconductor devices where the gate electrodes of the adjacent semiconductor devices are conductively connected above the dielectric wall. First and second adjacent semiconductor devices each include a gate structure around or otherwise on a semiconductor region. The gate structures each include a gate dielectric and a gate electrode. A dielectric wall may extend in the first direction between the semiconductor regions of the adjacent devices and in a third direction along a portion of a total height of the adjacent gate structures. Accordingly, a portion of the gate electrode of the first device contacts a portion of the gate electrode of the second device over a top surface of the dielectric wall. The dielectric wall separates the gate dielectric of the first device from contacting any portion of the gate dielectric of the second device.

## Description

### BACKGROUND

As integrated circuits continue to scale downward in size, a number of challenges arise. For instance, reducing the size of memory and logic cells is becoming increasingly more difficult, as is reducing device spacing at the device layer. As transistors are packed more densely, the formation of certain device structures used to isolate adjacent transistors becomes challenging. Accordingly, there remain a number of non-trivial challenges with respect to forming semiconductor devices.

### BRIEF DESCRIPTION OFTHE DRAWINGS

Figures 1A and 1B are cross-sectional and plan views, respectively, of some semiconductor devices that illustrate a dielectric wall between adjacent devices where portions of the gate electrodes from the adjacent devices contact each other above the dielectric wall, in accordance with an embodiment of the present disclosure.
Figures 2A - 2M are cross-sectional views that illustrate various stages in an example process for forming a portion of an integrated circuit that has a dielectric wall between adjacent devices where portions of the gate electrodes from the adjacent devices contact each other above the dielectric wall, in accordance with some embodiments of the present disclosure.
Figure 3 is a cross-sectional view of semiconductor devices having a dielectric wall between adjacent devices where portions of the gate electrodes from the adjacent devices contact each other above the dielectric wall, in accordance with some other embodiments of the present disclosure.
Figure 4 illustrates a cross-sectional view of a chip package containing one or more semiconductor dies, in accordance with some embodiments of the present disclosure.
Figure 5 is a flowchart of a fabrication process for a portion of an integrated circuit having a dielectric wall between adjacent devices where portions of the gate electrodes from the adjacent devices contact each other above the dielectric wall, in accordance with an embodiment of the present disclosure.
Figure 6 illustrates a computing system including one or more integrated circuits, as variously described herein, in accordance with an embodiment of the present disclosure.

Although the following Detailed Description will proceed with reference being made to illustrative embodiments, many alternatives, modifications, and variations thereof will be apparent in light of this disclosure. As will be further appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles (e.g., some features may have tapered sidewalls and/or rounded corners), and some features may have surface topology or otherwise be non-smooth, given real world limitations of the processing equipment and techniques used.

### DETAILED DESCRIPTION

Techniques are provided herein to form semiconductor devices that include a dielectric wall between adjacent semiconductor devices where the gate electrodes of the adjacent semiconductor devices are conductively connected above the dielectric wall. The techniques can be used in any number of integrated circuit applications and are particularly useful with respect to device layer transistors, such as finFETs or gate-all-around transistors (e.g., ribbonFETs and nanowire FETs) or forksheet transistors (e.g., nanosheet FETs). In an example, first and second adjacent semiconductor devices each include a gate structure around or otherwise on a semiconductor region (also referred to as a channel region). The semiconductor regions of the adjacent devices can be, for example, fins of semiconductor material that extend parallel to each other along a first direction from a source region to a drain region, or one or more nanowires or nanoribbons or nanosheets of semiconductor material that extend parallel to each other along the first direction from a source region to a drain region. The gate structures each include a gate dielectric (e.g., high-k gate dielectric material) and a gate electrode (e.g., conductive material such as workfunction material and/or gate fill metal). A dielectric wall may extend in the first direction between the semiconductor regions of the adjacent devices and in a third direction (e.g., vertical direction) along a portion of a total height of the adjacent gate structures. Accordingly, a portion of the gate electrode of the first device contacts a portion of the gate electrode of the second device over a top surface of the dielectric wall. Additionally, the dielectric wall separates the gate dielectric of the first device from contacting any portion of the gate dielectric of the second device. According to some embodiments, the dielectric wall is fully contained within the gate trench such that the dielectric wall does not extend beyond the gate spacer structures along the first direction. The dielectric wall may include any number of dielectric layers, such as a dielectric liner and a dielectric fill on the dielectric liner. Numerous variations and embodiments will be apparent in light of this disclosure.

### General Overview

As previously noted above, there remain a number of non-trivial challenges with respect to integrated circuit fabrication. In more detail, as devices become smaller and more densely packed, many structures become more challenging to fabricate as critical dimensions (CD) of the structures push the limits of current fabrication technology. In many circuit designs, both n-channel and p-channel transistors are used, with both types of transistors often sharing a same gate trench, such that the gates of the n-channel and p-channel devices are connected together. The gate electrodes of n-channel and p-channel devices include different metal layers, such that a boundary exists between the different metal layers between the n-channel and p-channel devices. If this boundary is too large, metal diffusion across the boundary can cause the device characteristics to shift in an undesirable manner. Additionally, oxygen vacancy diffusion through the gate dielectric extending between both the n-channel and p-channel devices causes further shifting of the device characteristics of both devices, which may compromise performance.

Thus, and in accordance with an embodiment of the present disclosure, techniques are provided herein to form a dielectric wall within the gate trench between adjacent devices to separate the gate dielectric between the devices while allowing the gate electrodes to contact each other above the dielectric wall (e.g., maintaining the gate-to-gate connection). In some embodiments, the dielectric wall includes a dielectric liner along edges of the dielectric wall that includes a high-k material (e.g., material with a dielectric constant greater than that of silicon dioxide which has a dielectric constant of 3.9, such as dielectrics having a dielectric constant greater than or equal to 6.5). The dielectric liner may include, for example, a conformal deposition of silicon nitride. Since the dielectric liner is along the edges of the dielectric wall, it may contact the gate electrode on either side of the dielectric wall. The dielectric wall may also include a dielectric fill on the dielectric liner and within an inner portion of the dielectric wall. According to some embodiments, the dielectric fill includes a medium-to-low-k material (e.g., material with a dielectric constant less than or equal to 4.5). Silicon dioxide or flowable silicon dioxide or porous silicon dioxide may be used for the dielectric fill, to provide a few examples. In still other embodiments, the dielectric wall may be entirely composed of a high-k material, such as silicon nitride.

According to some embodiments, the dielectric wall does not extend along the entire height of the adjacent gate structures, such that the gate electrodes are conductively connected over the top surface of the dielectric wall. In some examples, the gate electrode from one device contacts the gate electrode of the other device over the top surface of the dielectric wall. In such examples, a seam may be present between the different electrode layers above the top surface of the dielectric wall. In some examples, a conductive fill extends over the top surface of the dielectric wall effectively forming a conductive bridge between the adjacent gate electrodes. According to some embodiments, the dielectric wall is formed within the gate trench after the formation of the gate dielectric for each of the adjacent devices. The gate dielectric between the devices may be removed during the formation of the dielectric wall, such that the dielectric wall separates the gate dielectric between the adjacent gate structures. In this way, the dielectric wall can prevent oxygen vacancy diffusion through the gate dielectric between the adjacent devices.

According to an embodiment, an integrated circuit includes a first semiconductor device having a first semiconductor region extending in a first direction from a first source or drain region and a first gate structure extending in a second direction over the first semiconductor region, a second semiconductor device having a second semiconductor region extending in the first direction from a second source or drain region and a second gate structure extending colinearlywith the first gate structure in the second direction and overthe second semiconductor region, and a dielectric wall between the first semiconductor region and the second semiconductor region and extending along a third direction through a portion of a height of the first and second gate structures. The first gate structure includes a first gate dielectric on the first semiconductor region and a first gate electrode, and the second gate structure includes a second gate dielectric on the second semiconductor region and a second gate electrode. The second gate electrode includes a different material than the first gate electrode. A portion of the first gate electrode contacts a portion of the second gate electrode above the dielectric wall. In some embodiments, the first semiconductor device is an n-channel device and the second semiconductor device is a p-channel device. Other examples may be reversed.

According to an embodiment, an integrated circuit includes a first semiconductor device having a first semiconductor region extending in a first direction from a first source or drain region and a first gate structure extending in a second direction over the first semiconductor region, a second semiconductor device having a second semiconductor region extending in the first direction from a second source or drain region and a second gate structure extending colinearlywith the first gate structure in the second direction and overthe second semiconductor region, and a dielectric wall between the first semiconductor region and the second semiconductor region and extending along a third direction through a portion of a height of the first and second gate structures. The first gate structure includes a first gate dielectric on the first semiconductor region and a first gate electrode, and the second gate structure includes a second gate dielectric on the second semiconductor region and a second gate electrode. The first gate dielectric and the second gate dielectric do not extend above a top surface of the dielectric wall, and the first gate electrode and the second gate electrode extend above the top surface of the dielectric wall. In some embodiments, the first semiconductor device is an n-channel device and the second semiconductor device is a p-channel device. Other examples may be reversed.

According to another embodiment, a method of forming an integrated circuit includes: forming a first fin comprising first semiconductor material and a second fin comprising second semiconductor material, the first and second fins extending above a substrate and each extending parallel to one another in a first direction; forming a sacrificial gate extending over the first and second fins in a second direction different from the first direction; forming spacer structures on sidewalls of the sacrificial gate; forming source or drain regions at ends of the first and second fins; removing the sacrificial gate; forming a gate dielectric on the first and second semiconductor material of the first and second fins and on inner sidewalls of the spacer structures; forming a sacrificial material over the first and second semiconductor material and over the gate dielectric; forming a recess through an entire thickness of the sacrificial material between the first and second semiconductor material; removing the gate dielectric exposed within the recess; forming a dielectric wall within the recess; recessing a top surface of the dielectric wall below a top surface of the spacer structures; removing the sacrificial material; forming a first gate electrode over the gate dielectric on the first semiconductor material; and forming a second gate electrode over the gate dielectric on the second semiconductor material.

The techniques can be used with any type of non-planar transistors, including finFETs (sometimes called tri-gate transistors), nanowire and nanoribbon transistors (sometimes called gate-all-around transistors), or forksheet transistors, to name a few examples. The source and drain regions can be, for example, epitaxial regions that are deposited during an etch-and-replace source/drain forming process. The dopant-type in the source and drain regions will depend on the polarity of the corresponding transistor. The gate structure can be implemented with a gate-first process or a gate-last process (sometimes called a replacement metal gate, or RMG, process). Any number of semiconductor materials can be used in forming the transistors, such as group IV materials (e.g., silicon, germanium, silicon germanium) or group III-V materials (e.g., gallium arsenide, indium gallium arsenide).

Use of the techniques and structures provided herein may be detectable using tools such as electron microscopy including scanning/transmission electron microscopy (SEMITEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. For instance, in some example embodiments, such tools may be used to detect the presence of a dielectric wall within the gate trench between adjacent gate structures, where the gate electrodes of the adjacent gate structures are connected over the top surface of the dielectric wall. In some examples, the dielectric wall is confined to the gate trench such that it does not extend beyond the spacer structures along the sides of the gate trench. In some examples, the gate dielectric does not extend above the top surface of the dielectric wall within the gate trench. In some examples, a seam may be present between the different electrode layers above the top surface of the dielectric wall. Numerous configurations and variations will be apparent in light of this disclosure.

It should be readily understood that the meaning of "above" and "over" in the present disclosure should be interpreted in the broadest manner such that "above" and "over" not only mean "directly on" something but also include the meaning of over something with an intermediate feature or a layer therebetween. Further, spatially relative terms, such as "beneath," "below," "lower," "above," "upper," "top," "bottom," and the like, may be used herein for ease of description to describe one element or feature's relationship to another element (s) or feature (s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

As used herein, the term "layer" refers to a material portion including a region with a thickness. A monolayer is a layer that consists of a single layer of atoms of a given material. A layer can extend over the entirety of an underlying or overlying structure, or may have an extent less than the extent of an underlying or overlying structure. Further, a layer can be a region of a homogeneous or inhomogeneous continuous structure, with the layer having a thickness less than the thickness of the continuous structure. For example, a layer can be located between any pair of horizontal planes between, or at, a top surface and a bottom surface of the continuous structure. A layer can extend horizontally, vertically, and/or along a tapered surface. A layer can be conformal to a given surface (whether flat or curvilinear) with a relatively uniform thickness across the entire layer.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer. If two materials are elementally different, then one of the materials has an element that is not in the other material.

### Architecture

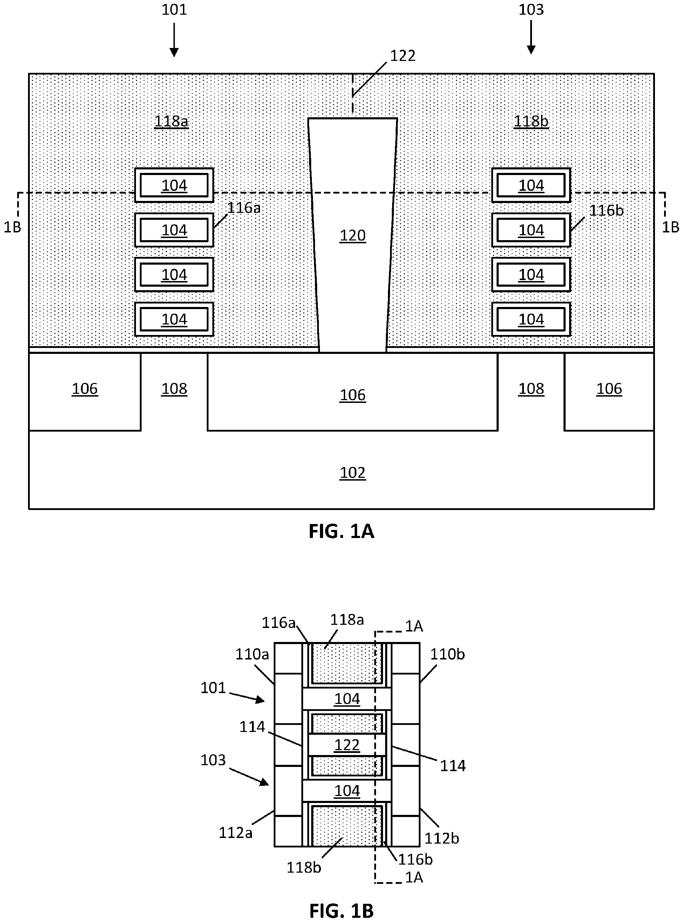

Figure 1A is a cross-sectional view taken across two example semiconductor devices 101 and 103, according to an embodiment of the present disclosure. Figure 1B is a top-down cross-section view of the adjacent semiconductor devices 101 and 103 taken across the dashed line 1B-1B depicted in Figure 1A, and Figure 1A illustrates the cross-section taken across the dashed line 1A-1A depicted in Figure 1B. Each of semiconductor devices 101 and 103 may be non-planar metal oxide semiconductor (MOS) transistors, such as tri-gate (e.g., finFET) or gate-all-around (GAA) transistors, although other transistor topologies and types could also benefit from the gate cut techniques and structures provided herein. The illustrated example embodiments herein use the GAA structure. Semiconductor devices 101 and 103 represent a portion of an integrated circuit that may contain any number of similar semiconductor devices.

As can be seen, semiconductor devices 101 and 103 are formed on a substrate 102. Any number of semiconductor devices can be formed on substrate 102, but two are used here as an example. Substrate 102 can be, for example, a bulk substrate including group IV semiconductor material (such as silicon, germanium, or silicon germanium), group III-V semiconductor material (such as gallium arsenide, indium gallium arsenide, or indium phosphide), and/or any other suitable material upon which transistors can be formed. Alternatively, substrate 102 can be a semiconductor-on-insulator substrate having a desired semiconductor layer over a buried insulator layer (e.g., silicon over silicon dioxide). Alternatively, substrate 102 can be a multilayer substrate or superlattice suitable for forming nanowires or nanoribbons (e.g., alternating layers of silicon and SiGe, or alternating layers indium gallium arsenide and indium phosphide). Any number of substrates can be used. In some example embodiments, a lower portion of (or all of) substrate 102 is removed and replaced with one or more backside interconnect layers to form backside signal and power routing.

Each of semiconductor devices 101 and 103 includes one or more nanoribbons 104 that extend parallel to one another along a direction between a source region and a drain region (e.g., a first direction into and out of the page in the cross-section view of Figure 1A). Nanoribbons 104 are one example of semiconductor regions or semiconductor bodies that extend between source and drain regions. The term nanoribbon may also encompass other similar shapes such as nanowires or nanosheets. The semiconductor material of nanoribbons 104 may be formed from substrate 102. In some embodiments, semiconductor devices 101 and 103 may each include semiconductor regions in the shape of fins that can be, for example, native to substrate 102 (formed from the substrate itself), such as silicon fins etched from a bulk silicon substrate. Alternatively, the fins can be formed of material deposited onto an underlying substrate. In one such example case, a blanket layer of silicon germanium (SiGe) can be deposited onto a silicon substrate, and then patterned and etched to form a plurality of SiGe fins extending from that substrate. In another such example, non-native fins can be formed in a so-called aspect ratio trapping based process, where native fins are etched away so as to leave fin-shaped trenches which can then be filled with an alternative semiconductor material (e.g., group IV or III-V material). In still other embodiments, the fins include alternating layers of material (e.g., alternating layers of silicon and SiGe) that facilitates forming of the illustrated nanoribbons 104 during a gate forming process where one type of the alternating layers is selectively etched away so as to liberate the other type of alternating layers within the channel region, so that a gate-all-around (GAA) process can then be carried out. Again, the alternating layers can be blanket deposited and then etched into fins or deposited into fin-shaped trenches, according to some examples.

As can further be seen, adjacent semiconductor devices are separated by a dielectric fill 106 that may include silicon dioxide. Dielectric fill 106 provides shallow trench isolation (STI) between adjacent subfin regions 108 of the semiconductor devices. Dielectric fill 106 can be any suitable dielectric material, such as silicon dioxide, aluminum oxide, or silicon oxycarbonitride.

According to some embodiments, subfin regions 108 comprise the same semiconductor material as substrate 102 and are adjacent to dielectric fill 106. According to some embodiments, nanoribbons 104 (or other semiconductor bodies) extend between a source and a drain region in the first direction to provide an active region for a transistor (e.g., the semiconductor region beneath the gate). The source and drain regions are not shown in the cross-section of Figure 1A, but are seen in the top-down view of Figure 1B where nanoribbons 104 of semiconductor device 101 extend between a first source or drain region 110a and a second source or drain region 110b (similarly, the nanoribbons 104 of semiconductor device 103 extend between a first source or drain region 112a and a second source or drain region 112b). Figure 1B also illustrates spacer structures 114 that extend around the ends of nanoribbons 104 and along sidewalls of the gate structures between spacer structures 114. Spacer structures 114 may include a dielectric material, such as silicon nitride.

According to some embodiments, the source and drain regions are epitaxial regions that are provided using an etch-and-replace process. In other embodiments one or both of the source and drain regions could be, for example, implantation-doped native portions of the semiconductor fins or substrate. Any semiconductor materials suitable for source and drain regions can be used (e.g., group IV and group III-V semiconductor materials). The source and drain regions may include multiple layers such as liners and capping layers to improve contact resistance. In any such cases, the composition and doping of the source and drain regions may be the same or different, depending on the polarity of the transistors. In an example, for instance, one transistor is a p-type MOS (PMOS) transistor, and the other transistor is an n-type MOS (NMOS) transistor. Any number of source and drain configurations and materials can be used.

According to some embodiments, a first gate structure extends over nanoribbons 104 of semiconductor device 101 along a second direction across the page while a second gate structure extends over nanoribbons 104 of semiconductor device 103 along the second direction. The second direction may be orthogonal to the first direction. Each gate structure includes a respective gate dielectric 116a/116b and a gate electrode 118a/118b. Gate dielectric 116a/116b represents any number of dielectric layers present between nanoribbons 104 and corresponding gate electrode 118a/118b. Gate dielectric 116a/116b may also be present on the surfaces of other structures within the gate trench, such as on subfin region 108. Gate dielectric 116a/116b may include any suitable gate dielectric material(s). In some embodiments, gate dielectric 116a/116b includes a layer of native oxide material (e.g., silicon dioxide) on the nanoribbons or other semiconductor regions making up the channel region of the devices, and a layer of high-K dielectric material (e.g., hafnium oxide) on the native oxide. Depending on the type of each of semiconductor devices 101 and 103, gate dielectric 116a may have a different doping composition compared to gate dielectric 116b. For example, gate dielectric 116a may have a first doping concentration of lanthanum suited for an n-channel device and gate dielectric 116b may have a second doping concentration of lanthanum suited for a p-channel device. The different doping concentrations used in the gate dielectric 116a/116b may affect the threshold voltages of semiconductor devices 101 and 103.

Gate electrode 118a/118b may represent any number of conductive layers, such as any metal, metal alloy, or doped polysilicon layers. In some embodiments, gate electrode 118a/118b includes one or more workfunction metals around nanoribbons 104. In some embodiments, semiconductor device 101 is an n-channel device that include a workfunction metal having tungsten around its nanoribbons 104 and semiconductor device 103 is a p-channel device that includes a workfunction metal having titanium around its nanoribbons 104. Gate electrode 118a/118b may also include a fill metal or other conductive material (e.g., tungsten, ruthenium, molybdenum, cobalt) around the workfunction metals to provide the whole gate electrode structure.

According to some embodiments, adjacent gate structures may be partially separated along the second direction (e.g., across the page) by a dielectric wall 120, which acts like a dielectric barrier between adjacent gate structures. Dielectric wall 120 extends vertically (e.g., in a third direction) along only a portion of the entire thickness of the adjacent gate structures, such that gate electrodes 118a/118b extend above a top surface of dielectric wall 120. In some embodiments, dielectric wall 120 does not extend into dielectric fill 106 (though it may in other embodiments). Dielectric wall 120 is formed from one or more dielectric materials. In one example, dielectric wall 120 is formed from a single high-k dielectric material, such as silicon nitride. In other examples, dielectric wall 120 includes a dielectric liner along an outer edge of dielectric wall 120 and a dielectric fill on the dielectric liner. According to some embodiments, the dielectric liner includes a high-k dielectric material, such as silicon nitride, and the dielectric fill includes a medium-k or low-k dielectric material (e.g., a dielectric having a dielectric constant of about 4.5 or less), such as silicon dioxide, porous silicon dioxide, or flowable oxide. Dielectric wall 120 may include one or more airgaps or voids within a central portion of dielectric wall 120. Dielectric wall 120 may have a top width along the second direction between about 10 nm and about 25 nm.

According to some embodiments, gate electrode 118a and gate electrode 118b extend over the top surface of dielectric wall 120 such that a seam 122 may be present at an interface between the gate electrodes. In some examples, seam 122 is between the different workfunction metal layers used for each of gate electrode 118a and gate electrode 118b. Seam 122 may be present anywhere over the top surface of dielectric wall 120 and does not need to be aligned along the center of dielectric wall 120. Additionally, seam 122 can be any shape and is provided as a straight line in the figure for clarity. In some embodiments, neither gate dielectric 116a nor gate dielectric 116b extends along the sidewalls of dielectric wall 120. Note that ends of gate dielectric 116a and gate dielectric 116b may abut dielectric wall 120, which is distinct from extending along dielectric wall 120, as will be appreciated. Furthermore, dielectric wall 120 cuts through gate dielectric 116a/116b along the bottom of the gate trench, such that gate dielectric 116a is isolated from gate dielectric 116b by dielectric wall 120.

According to some embodiments, dielectric wall 120 extends in the first direction across the entire width of the gate trench as seen in Figure 1B but is confined to the gate trench. Accordingly, dielectric wall 120 does not extend beyond spacer structures 114 along the first direction.

### Fabrication Methodology

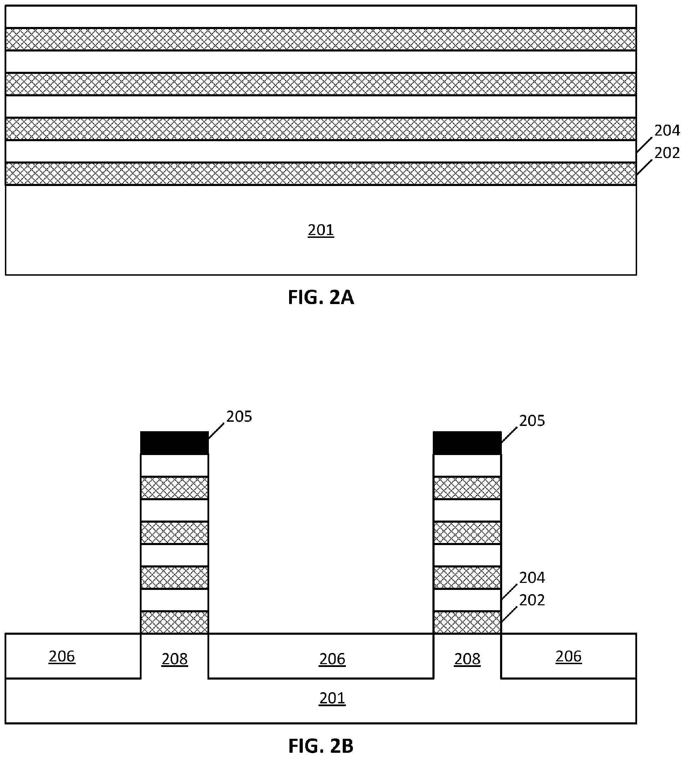

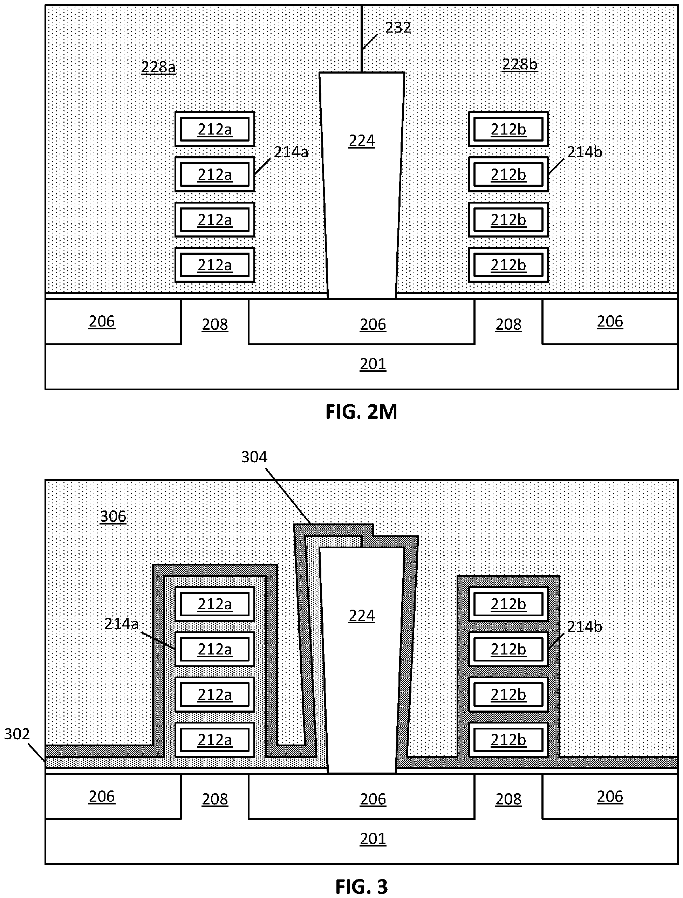

Figures 2A - 2M include cross-sectional views that collectively illustrate an example process for forming an integrated circuit having a dielectric wall between adjacent semiconductor devices where portions of the gate electrodes from the adjacent devices contact each other above the dielectric wall, in accordance with an embodiment of the present disclosure. Each figure shows an example structure that results from the process flow up to that point in time, so the depicted structure evolves as the process flow continues, culminating in the structure shown in Figure 2M, which is similar to the structure shown in Figure 1A. The illustrated integrated circuit structure may be part of a larger integrated circuitthat includes other integrated circuitry not depicted. Example materials and process parameters are given, but the present disclosure is not intended to be limited to any specific such materials or parameters, as will be appreciated. Although the fabrication of a single dielectric wall is illustrated in the aforementioned figures, it should be understood that any number of similar dielectric walls can be fabricated across the integrated circuit using the same processes discussed herein.

Figure 2A illustrates a cross-sectional view taken through a substrate 201 having a series of material layers formed over the substrate, according to an embodiment of the present disclosure. Alternating material layers may be deposited over substrate 201 including sacrificial layers 202 alternating with semiconductor layers 204. The alternating layers are used to form GAA transistor structures. Any number of alternating semiconductor layers 204 and sacrificial layers 202 may be deposited over substrate 201. The description above for substrate 102 applies equally to substrate 201.

According to some embodiments, sacrificial layers 202 have a different material composition than semiconductor layers 204. In some embodiments, sacrificial layers 202 are silicon germanium (SiGe) while semiconductor layers 204 include a semiconductor material suitable for use as a nanoribbon such as silicon (Si), SiGe, germanium, or III-V materials like indium phosphide (InP) or gallium arsenide (GaAs). In examples where SiGe is used in each of sacrificial layers 202 and in semiconductor layers 204, the germanium concentration is different between sacrificial layers 202 and semiconductor layers 204. For example, sacrificial layers 202 may include a higher germanium content compared to semiconductor layers 204.

While dimensions can vary from one example embodiment to the next, the thickness of each sacrificial layer 202 may be between about 5 nm and about 20 nm. In some embodiments, the thickness of each sacrificial layer 202 is substantially the same (e.g., within 1-2 nm). The thickness of each of semiconductor layers 204 may be about the same as the thickness of each sacrificial layer 202 (e.g., about 5-20 nm). Each of sacrificial layers 202 and semiconductor layers 204 may be deposited using any known or proprietary material deposition technique, such as chemical vapor deposition (CVD), plasma-enhanced chemical vapor deposition (PECVD), physical vapor deposition (PVD), or atomic layer deposition (ALD).

Figure 2B depicts the cross-section view of the structure shown in Figure 2A following the formation of a cap layer 205 and the subsequent formation of fins beneath cap layer 205, according to an embodiment. Cap layer 205 may be any suitable hard mask material such as a carbon hard mask (CHM) or silicon nitride. Cap layer 205 is patterned into rows to form corresponding rows of fins from the alternating layer stack of sacrificial layers 202 and semiconductor layers 204. The rows of fins extend lengthwise in a first direction (e.g., into and out of the page).

According to some embodiments, an anisotropic etching process through the layer stack continues into at least a portion of substrate 201. The etched portion of substrate 201 may be filled with a dielectric fill 206 that acts as shallow trench isolation (STI) between adjacent fins. Dielectric fill 206 may be any suitable dielectric material such as silicon dioxide. Subfin regions 208 represent remaining portions of substrate 201 between dielectric fill 206, according to some embodiments.

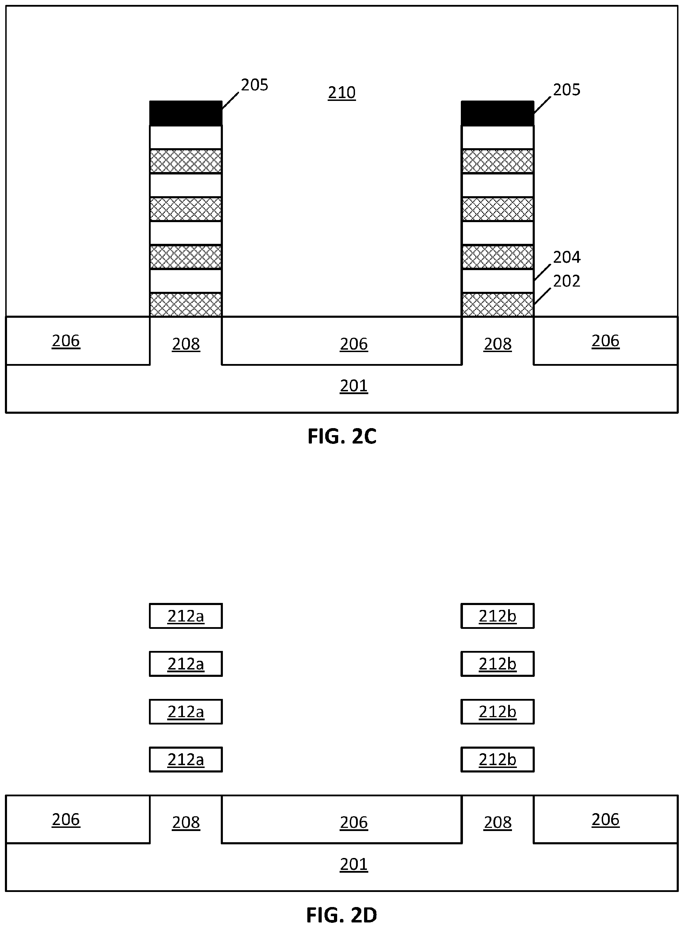

Figure 2C depicts the cross-section view of the structure shown in Figure 2B following the formation of a sacrificial gate 210 extending across the fins in a second direction different from the first direction, according to some embodiments. Sacrificial gate 210 may extend across the fins in a second direction that is orthogonal to the first direction. According to some embodiments, the sacrificial gate material is formed in parallel strips across the integrated circuit and removed in all areas not protected by a gate masking layer. Sacrificial gate 210 may be any suitable material that can be selectively removed without damaging the semiconductor material of the fins. In some examples, sacrificial gate 210 includes polysilicon.

Following the formation of sacrificial gate 210 (and prior to replacement of sacrificial gate 210 with a metal gate), additional semiconductor device structures are formed that are not shown in these cross-sections. These additional structures include spacer structures on the sidewalls of sacrificial gate 210 that extend along the second direction with sacrificial gate 210, and source and drain regions on either ends of each of the fins. The formation of such structures can be accomplished using any number of processing techniques.

Figure 2D depicts the cross-section view of the structure shown in Figure 2C following the removal of sacrificial gate 210 and the removal of sacrificial layers 202, according to some embodiments. In examples where any gate masking layers are still present, they may also be removed at this time. Once sacrificial gate 210 is removed, the fins that had been beneath sacrificial gate 210 are exposed.

In the example where the fins include alternating semiconductor layers, sacrificial layers 202 are selectively removed to release nanoribbons 212a/212b that extend between corresponding source or drain regions. Each vertical set of nanoribbons 212a/212b represents the semiconductor or channel region of a different semiconductor device. It should be understood that nanoribbons 212a/212b may also be nanowires or nanosheets (e.g., from a forksheet arrangement) or fins (e.g., for a finFET arrangement). Sacrificial gate 210 and sacrificial layers 202 may be removed using the same isotropic etching process or different isotropic etching processes.

According to some embodiments, first nanoribbons 212a are part of a first semiconductor device and second nanoribbons 212b are part of an adjacent second semiconductor device. The first semiconductor device may be an n-channel device having source and drain regions at the ends of first nanoribbons 212a that include silicon doped with phosphorous. The second semiconductor device may be a p-channel device having source and drain regions at the ends of second nanoribbons 212b that include silicon germanium doped with boron.

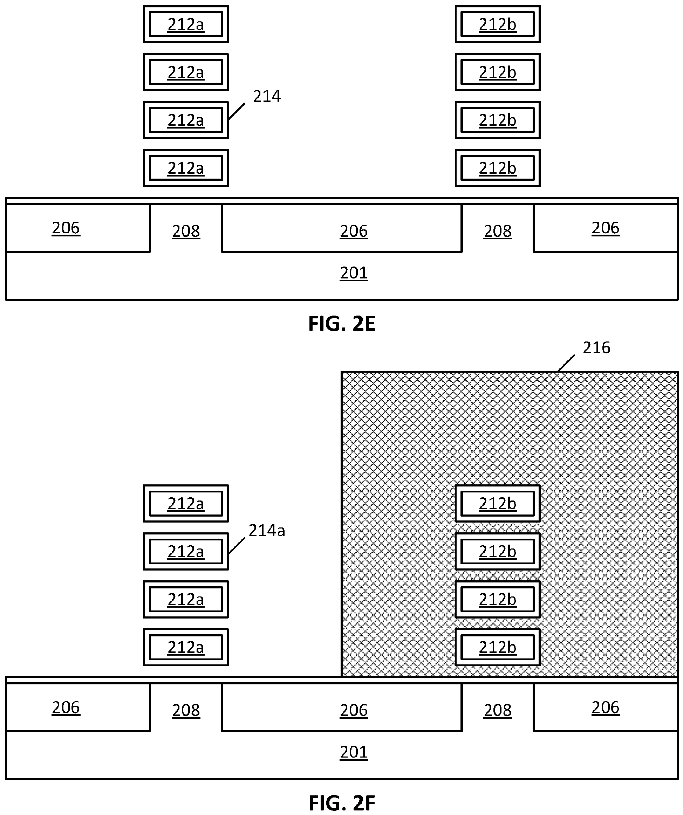

Figure 2E depicts the cross-section view of the structure shown in Figure 2D following the formation of at least part of a gate dielectric 214 over first nanoribbons 212a and second nanoribbons 212b, according to some embodiments. Gate dielectric 214 may be formed on all exposed surfaces within the gate trench, including along the inner surfaces of the spacer structures and on the top surfaces of dielectric fill 206 and subfin regions 208.

The gate dielectric 214 may include any suitable dielectric material (such as silicon dioxide, and/or a high-k dielectric material). Examples of high-k dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate, to provide some examples. According to some embodiments, gate dielectric 214 includes a layer of hafnium oxide with a thickness between about 1 nm and about 5 nm. In some embodiments, gate dielectric 214 may include one or more silicates (e.g., titanium silicate, tungsten silicate, niobium silicate, and silicates of other transition metals). In some cases, gate dielectric 214 may include a first layer on nanoribbons 212a/212b, and a second layer on the first layer. The first layer can be, for instance, an oxide of the semiconductor material of nanoribbons 212a/212b (e.g., silicon dioxide) and the second layer can be a high-k dielectric material (e.g., hafnium oxide). More generally, gate dielectric 214 can include any number of dielectric layers.

Figure 2F depicts the cross-section view of the structure shown in Figure 2E following the masking of the second semiconductor device and subsequent processing of the exposed portions of gate dielectric 214 to form a first gate dielectric 214a around first nanoribbons 212a, according to some embodiments. A mask structure 216 may be formed within the gate trench over second nanoribbons 212b. Mask structure 216 may be any suitable masking material that can be selectively removed without damaging surrounding structures. In some examples, mask structure 216 includes CHM or another suitable hard mask material. According to some embodiments, the exposed gate dielectric 214 not protected by mask structure 216 is doped with a first lanthanum concentration to adjust a threshold voltage for the first semiconductor device that is appropriate for an n-channel device.

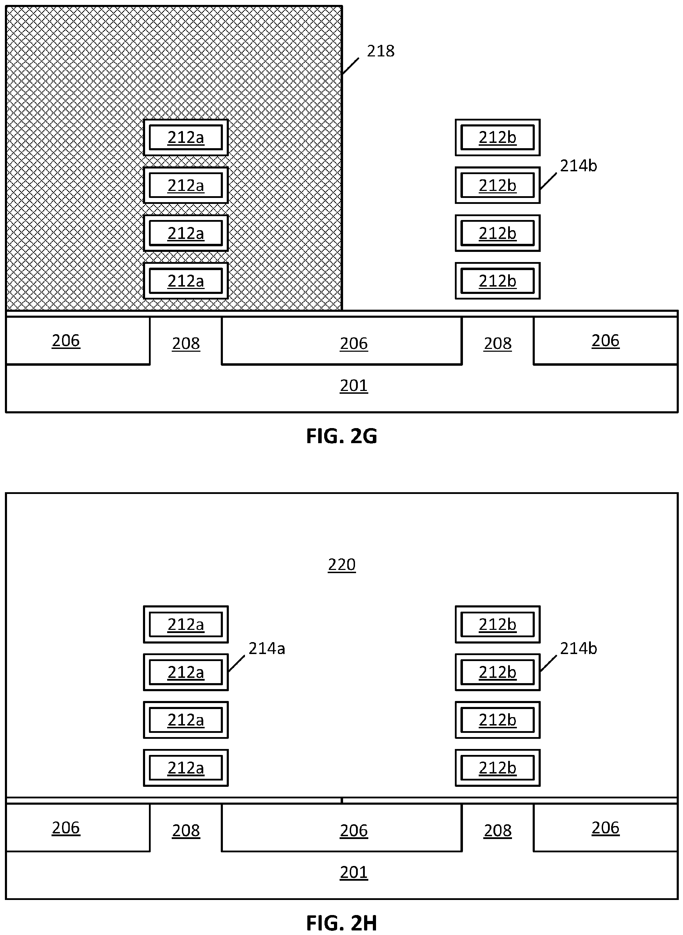

Figure 2G depicts the cross-section view of the structure shown in Figure 2F following the masking of the first semiconductor device and subsequent processing of the exposed portions of gate dielectric 214 to form a second gate dielectric 214b around second nanoribbons 212b, according to some embodiments. A mask structure 218 may be formed within the gate trench over first nanoribbons 212a. Mask structure 218 may be any suitable masking material that can be selectively removed without damaging surrounding structures. In some examples, mask structure 218 includes CHM or another suitable hard mask material. According to some embodiments, the exposed gate dielectric 214 not protected by mask structure 218 is doped with a second lanthanum concentration different from the first lanthanum concentration to adjust a threshold voltage for the second semiconductor device that is appropriate for a p-channel device. It should be noted that first and second gate dielectrics 214a/214b can be formed in any order.

Figure 2H depicts the cross-section view of the structure shown in Figure 2G following the removal of any masking structures within the gate trench and formation of a sacrificial material 220 within the gate trench, according to some embodiments. Sacrificial material 220 may be formed to the top of the gate trench and polished such that a top surface of sacrificial material 220 is substantially coplanar with a top surface of the spacer structures on either side of the gate trench. According to some embodiments, sacrificial material is any suitable masking material that can be selectively removed without damaging surrounding structures, such as CHM.

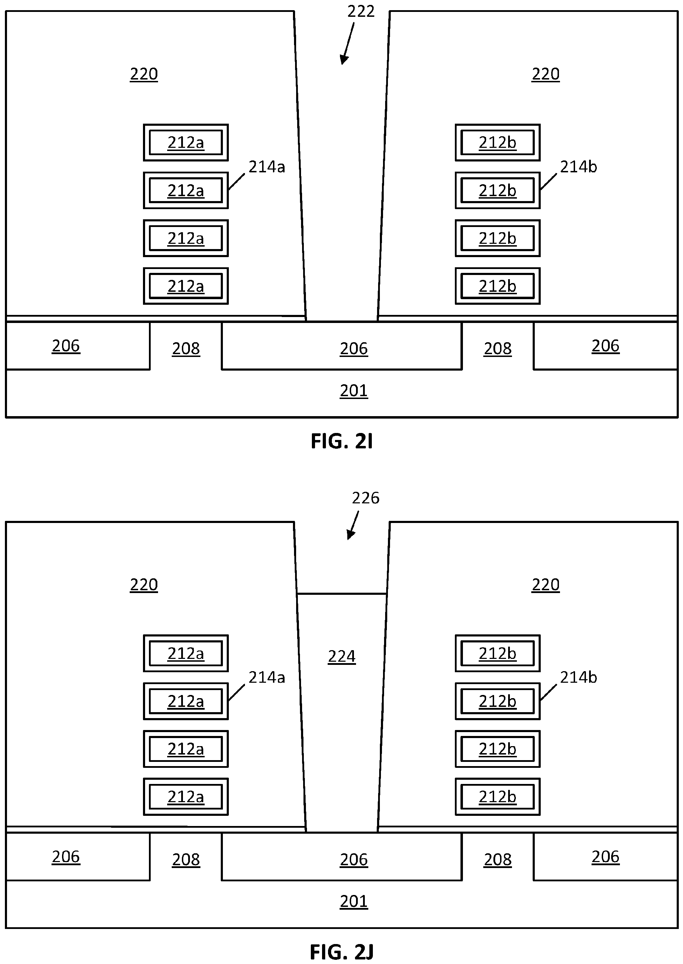

Figure 2I depicts the cross-section view of the structure shown in Figure 2H following the formation of a recess 222 through at least an entire thickness of sacrificial material 220, according to some embodiments. Recess 222 may have a high height-to-width aspect ratio of 5:1 or more, such as between 6:1 and 10:1. Recess 222 may be tapered and have a largest width along a top surface of sacrificial material 220 between about 20 nm and about 40 nm. According to some embodiments, recess 222 is confined within the gate trench such that recess 222 does not extend in the first direction (e.g., into and out of the page) further than the gate spacers on either side of the gate trench.

According to some embodiments, gate cut recess 222 also extends through gate dielectric 214, thus isolating first gate dielectric 214a from second gate dielectric 214b. In an example, a recess is first formed through the entire thickness of sacrificial material 220 using any suitable anisotropic etching process, such as reactive ion etching (RIE), which exposes gate dielectric 214 on the inner sidewalls of the spacer structures and on the bottom surface of the recess. Then, one or more isotropic etching processes may be performed to remove the exposed gate dielectric within the recess. According to some embodiments, any exposed portion of the gate dielectric within the recess is removed. In some examples, a bottom of recess 222 terminates on the top surface of dielectric fill 206.

Figure 2J depicts the cross-section view of the structure shown in Figure 2I following the formation and subsequent recessing of dielectric wall 224 within recess 222, according to some embodiments. Dielectric wall 224 may include a single high-k dielectric material, such as silicon nitride, or any suitable dielectric material, like silicon dioxide or silicon oxynitride. Dielectric wall 224 may be formed by first depositing dielectric material to substantially fill recess 222 and subsequently recessing the top surface of the dielectric material below a top surface of sacrificial material 220 to form a cavity 226. Dielectric wall 224 may be recessed using any suitable isotropic etching process. According to some embodiments, the dielectric material of dielectric wall 224 may be different from the dielectric material of the spacer structures to provide etch selectivity between dielectric wall 224 and the spacer structures during the recessing of dielectric wall 224. According to some embodiments, the top surface of dielectric wall 224 is recessed to a height between the top surface of sacrificial material 220 and a top surface of the topmost nanoribbon 212a/212b. As discussed above, dielectric wall 224 is confined within the gate trench and does not extend in the first direction (e.g., into and out of the page) further than the gate spacers on either side of the gate trench.

According to some embodiments, sacrificial material 220 is also recessed below a top surface of the gate trench, such as to about the same level as the top surface of dielectric wall 224. Recessing sacrificial material 220 exposes top portions of gate dielectric 214a/214b on the inner sidewalls of the spacer structures. These top portions of gate dielectric 214a/214b may be subsequently removed using any suitable isotropic etching process. As a result, gate dielectric 214a/214b may not extend above the top surface of dielectric wall 224 or at the very least does not extend to the top of the gate trench along the inner sidewalls of the spacer structures.

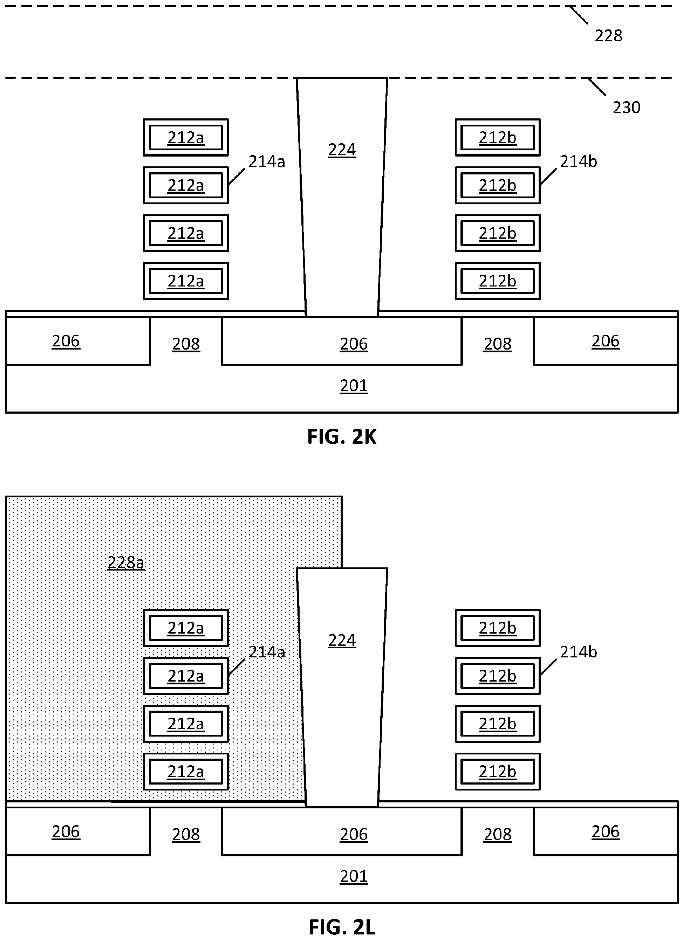

Figure 2K depicts the cross-section view of the structure shown in Figure 2J following the removal of sacrificial material 220, according to some embodiments. Dielectric wall 224 is left behind between first nanoribbons 212a and second nanoribbons 212b in the gate trench. A top surface of the gate trench (e.g., top surface of the spacer structures along the sides of the gate trench) is identified by plane 228. As can be observed, dielectric wall 224 is recessed below the top surface of the gate trench. According to some embodiments, gate dielectric 214a/214b is absent above plane 230. Thus, in some embodiments, gate dielectric 214a/214b is not present along the sidewalls of a top portion of the gate trench above first nanoribbons 212a and second nanoribbons 212b. Plane 230 may be substantially coplanar (e.g., within 5 nm) with a top surface of dielectric wall 224. In some embodiments, plane 230 may be at any location between plane 228 at the top surface of the gate trench and a top surface of the topmost nanoribbon 212a/212b. According to some embodiments, plane 230 identifies the top surface of the recessed sacrificial material 220 following the formation of dielectric wall 224.

Figure 2L depicts the cross-section view of the structure shown in Figure 2K following the formation of a first gate electrode 228a over first nanoribbons 212a and on first gate dielectric 214a, according to some embodiments. As noted above, first gate electrode 228a can represent any number of conductive layers. First gate electrode 228a may be deposited using electroplating, electroless plating, CVD, PECVD, ALD, or PVD, to name a few examples. In some embodiments, first gate electrode 228a includes a metal, or a metal alloy. Example suitable metals or metal alloys include aluminum, tungsten, cobalt, molybdenum, ruthenium, titanium, tantalum, copper, and carbides and nitrides thereof. First gate electrode 228a may include, for instance, a metal fill material (e.g., tungsten) along with one or more workfunction layers, resistance-reducing layers, and/or barrier layers. The workfunction layers of first gate electrode 228a can include n-type workfunction materials (e.g., titanium aluminum carbide or tungsten) for an NMOS gate. Second nanoribbons 212b and second gate dielectric 214b may be protected by a masking structure during formation of first gate electrode 228a that is subsequently removed following the formation of first gate electrode 228a or at least a portion of first gate electrode 228a.

Figure 2M depicts the cross-section view of the structure shown in Figure 2L following the formation of a second gate electrode 228b over second nanoribbons 212b and on second gate dielectric 214b, according to some embodiments. Similar to first gate electrode 228a, second gate electrode 228b can represent any number of conductive layers and may be deposited using electroplating, electroless plating, CVD, PECVD, ALD, or PVD, to name a few examples. Second gate electrode 228b may also include a metal fill material (e.g., tungsten) along with one or more workfunction layers, resistance-reducing layers, and/or barrier layers. The workfunction layers of second gate electrode 228b can include p-type workfunction materials (e.g., titanium nitride) for a PMOS gate.

Since first gate electrode 228a (or at least a portion of first gate electrode 228a) is already present, second gate electrode 228b (or at least a portion of second gate electrode 228b) will contact at least a portion of first gate electrode 228a above dielectric wall 224, according to some embodiments. A seam 232 may be observed at the boundary between at least a portion of first gate electrode 228a and at least a portion of second gate electrode 228b. For example, a workfunction metal layer of first gate electrode 228a may contact a workfunction metal layer of second gate electrode 228b above the top surface of dielectric wall 224. In some embodiments, a metal fill of first gate electrode 228a contacts a metal fill of second gate electrode 228b above the top surface of dielectric wall 224. In some embodiments, a same metal fill layer extends across the top surface of dielectric wall 224 and over both first nanoribbons 212a and second nanoribbons 212b.

Figure 3 illustrates one example arrangement of gate electrodes across two adjacent devices. Example workfunction metal layers are also illustrated. According to some embodiments, a first workfunction layer 302 is first deposited directly on first gate dielectric 214a and around first nanoribbons 212a (while second nanoribbons 212b are protected by a mask structure). According to some such embodiments, any mask structures within the gate trench are removed and a second workfunction layer 304 is deposited over all nanoribbons 212a/212b. Second workfunction layer 304 may be deposited directly on second gate dielectric 214b around second nanoribbons 212b and directly on first workfunction layer 302 around first nanoribbons 212a. In this way, first workfunction layer 302 is directly on first gate dielectric 214a while second workfunction layer 304 is directly on second gate dielectric 214b. According to some embodiments, second workfunction layer 304 contacts first work function layer 302 over the top surface of dielectric wall 224. Each of first workfunction layer 302 and second workfunction layer 304 may contact a portion of the top surface of dielectric wall 224. First workfunction layer 302 and second workfunction layer 304 may be deposited using any suitable deposition technique, such as CVD or ALD. First workfunction layer 302 may be a workfunction metal used for n-channel devices, such as tungsten. Second workfunction layer 304 may be a workfunction metal used for p-channel devices, such as titanium nitride. Other examples may be configured differently.

Following the formation of the workfunction metals for n-channel and p-channel devices, a metal fill 306 may be formed to fill any remaining volume within the gate trench, according to some embodiments. Metal fill 306 may be any suitable conductive material, such as tungsten, ruthenium, molybdenum, or cobalt. In the illustrated example, metal fill 306 bridges across the top of dielectric wall 224.

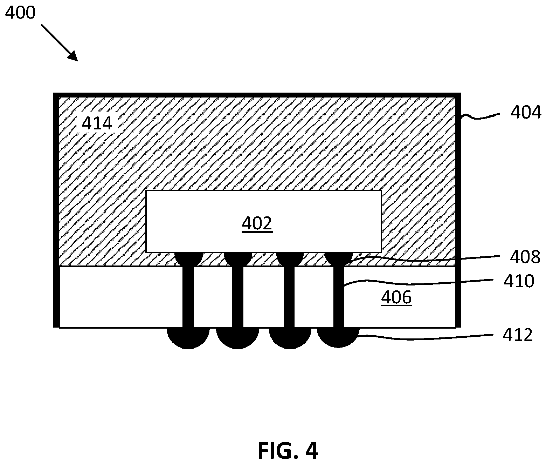

Figure 4 illustrates an example embodiment of a chip package 400, in accordance with an embodiment of the present disclosure. As can be seen, chip package 400 includes one or more dies 402. One or more dies 402 may include at least one integrated circuit having semiconductor devices, such as any of the semiconductor devices disclosed herein. One or more dies 402 may include any other circuitry used to interface with other devices formed on the dies, or other devices connected to chip package 400, in some example configurations.

As can be further seen, chip package 400 includes a housing 404 that is bonded to a package substrate 406. The housing 404 may be any standard or proprietary housing, and may provide, for example, electromagnetic shielding and environmental protection for the components of chip package 400. The one or more dies 402 may be conductively coupled to a package substrate 406 using connections 408, which may be implemented with any number of standard or proprietary connection mechanisms, such as solder bumps, ball grid array (BGA), pins, or wire bonds, to name a few examples. Package substrate 406 may be any standard or proprietary package substrate, but in some cases includes a dielectric material having conductive pathways (e.g., including conductive vias and lines) extending through the dielectric material between the faces of package substrate 406, or between different locations on each face. In some embodiments, package substrate 406 may have a thickness less than 1 millimeter (e.g., between 0.1 millimeters and 0.5 millimeters), although any number of package geometries can be used. Additional conductive contacts 412 may be disposed at an opposite face of package substrate 406 for conductively contacting, for instance, a printed circuit board (PCB). One or more vias 410 extend through a thickness of package substrate 406 to provide conductive pathways between one or more of connections 408 to one or more of contacts 412. Vias 410 are illustrated as single straight columns through package substrate 406 for ease of illustration, although other configurations can be used (e.g., damascene, dual damascene, through-silicon via, or an interconnect structure that meanders through the thickness of substrate 406 to contact one or more intermediate locations therein). In still other embodiments, vias 410 are fabricated by multiple smaller stacked vias, or are staggered at different locations across package substrate 406. In the illustrated embodiment, contacts 412 are solder balls (e.g., for bump-based connections or a ball grid array arrangement), but any suitable package bonding mechanism may be used (e.g., pins in a pin grid array arrangement or lands in a land grid array arrangement). In some embodiments, a solder resist is disposed between contacts 412, to inhibit shorting.

In some embodiments, a mold material 414 may be disposed around the one or more dies 402 included within housing 404 (e.g., between dies 402 and package substrate 406 as an underfill material, as well as between dies 402 and housing 404 as an overfill material). Although the dimensions and qualities of the mold material 414 can vary from one embodiment to the next, in some embodiments, a thickness of mold material 414 is less than 1 millimeter. Example materials that may be used for mold material 414 include epoxy mold materials, as suitable. In some cases, the mold material 414 is thermally conductive, in addition to being electrically insulating.

### Methodology

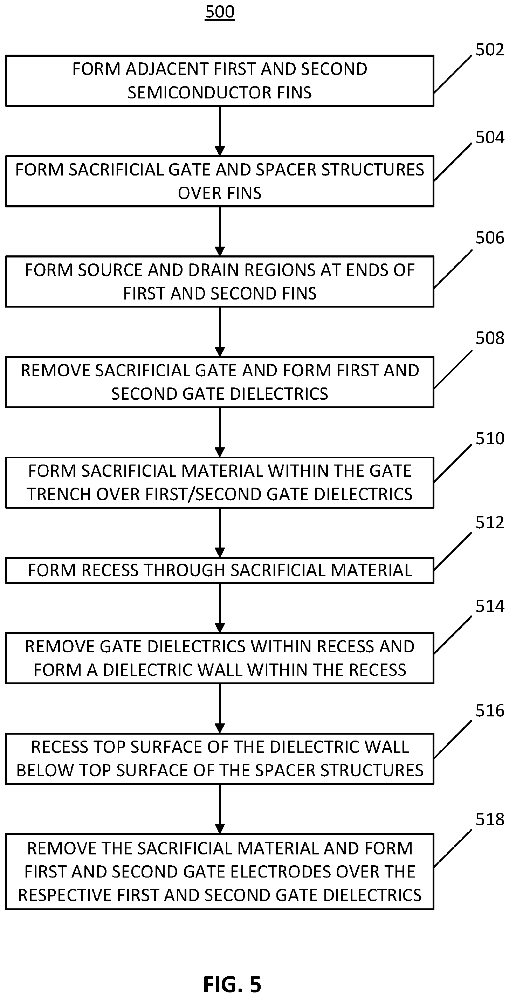

Figure 5 is a flow chart of a method 500 for forming at least a portion of an integrated circuit, according to an embodiment. Various operations of method 500 may be illustrated in Figures 2A-2M. However, the correlation of the various operations of method 500 to the specific components illustrated in the aforementioned figures is not intended to imply any structural and/or use limitations. Rather, the aforementioned figures provide one example embodiment of method 500. Other operations may be performed before, during, or after any of the operations of method 500. For example, method 500 does not explicitly describe all processes that are performed to form common transistor structures. Some of the operations of method 500 may be performed in a different order than the illustrated order.

Method 500 begins with operation 502 where any number of parallel semiconductor fins are formed, such as at least first and second adjacent fins according to some embodiments. The semiconductor material in the fins may be formed from a substrate such that the fins are an integral part of the substrate (e.g., etched from a bulk silicon substrate). Alternatively, the fins can be formed of material deposited onto an underlying substrate. In one such example case, a blanket layer of silicon germanium (SiGe) can be deposited onto a silicon substrate, and then patterned and etched to form a plurality of SiGe fins extending from that substrate. In another such example, the fins include alternating layers of material (e.g., alternating layers of silicon and SiGe) that facilitates forming of nanowires and nanoribbons during a gate forming process where one type of the alternating layers are selectively etched away so as to liberate the other type of alternating layers within the channel region, so that a gate-all-around (GAA) process can then be carried out. The alternating layers can be blanket deposited and then etched into fins, or deposited into fin-shaped trenches. The fins may also include a cap structure over each fin that is used to define the locations of the fins during, for example, an RIE process. The cap structure may be a dielectric material, such as silicon nitride.

According to some embodiments, a dielectric layer is formed around subfin portions of the one or more fins. In some embodiments, the dielectric layer extends between each pair of adjacent parallel fins and runs lengthwise in the same direction as the fins. In some embodiments, the anisotropic etching process that forms the fins also etches into a portion of the substrate and the dielectric layer may be formed within the recessed portions of the substrate. Accordingly, the dielectric layer acts as shallow trench isolation (STI) between adjacent fins. The dielectric layer may be any suitable dielectric material, such as silicon dioxide.

Method 500 continues with operation 504 where a sacrificial gate and spacer structures are formed over the fins. The sacrificial gate may be patterned using a gate masking layer in a strip that runs orthogonally over the fins (many gate masking layers and corresponding sacrificial gates may be formed parallel to one another (e.g., forming a cross-hatch pattern with the fins). The gate masking layer may be any suitable hard mask material, such as CHM or silicon nitride. The sacrificial gate may be formed from any suitable material that can be selectively removed at a later time without damaging the semiconductor material of the fins. In one example, the sacrificial gate includes polysilicon. The spacer structures may be deposited and then etched back such that the spacer structures remain mostly only on sidewalls of any exposed structures. According to some embodiments, the spacer structures may be any suitable dielectric material, such as silicon nitride or silicon oxynitride.

Method 500 continues with operation 506 where source or drain regions are formed at the ends of the semiconductor regions of each of the fins. Any portions of the fins not protected by the sacrificial gate and spacer structures may be removed using, for example, an anisotropic etching process followed by the epitaxial growth of the source or drain regions from the exposed ends of the semiconductor layers in the fins. In some example embodiments, the source or drain regions formed at the ends of the first fin are NMOS source or drain regions (e.g., epitaxial silicon) and the source or drain regions formed at the ends of the second fin are PMOS source or drain regions (e.g., epitaxial SiGe). Another dielectric fill may be formed adjacent to the various source or drain regions for additional electrical isolation between adjacent regions. The dielectric fill may also extend over a top surface of the source or drain regions. In some embodiments, topside conductive contacts may be formed through the dielectric fill to contact one or more of the source or drain regions.

Method 500 continues with operation 508 where the sacrificial gate is removed and gate dielectrics are formed over the semiconductor material of the first and second fins. The sacrificial gate may be removed using an isotropic etching process that selectively removes all of the material from the sacrificial gate, thus exposing the first and second fins between the set of spacer structures. In the example case where GAA transistors are used, any sacrificial layers within the exposed fins between the spacer structures may also be removed to release nanoribbons, nanosheets, or nanowires of semiconductor material.

A gate dielectric may be formed over the exposed semiconductor regions of the first and second fins between the spacer structures, according to some embodiments. The gate dielectric may include any number of dielectric layers deposited using a CVD process, such as ALD. According to some embodiments, the portion of the gate dielectric around the semiconductor regions of the first fin may be doped differently compared to the portion of the gate dielectric around the semiconductor regions of the second fin. The differently doped portions of the gate dielectric can be used to adjust the threshold voltage of the different semiconductor devices. In some embodiments, a first material layer containing a given concentration of lanthanum is deposited over a given portion of the gate dielectric (e.g., around the semiconductor material of a given number of fins) and an annealing process is used to drive the lanthanum dopant into the gate dielectric. In some examples, a second material layer is deposited over the first material layer to provide added protection during the annealing process. The second material layer may include titanium nitride. The first and second material layers may be removed following the doping process of the gate dielectric. The differently doped portions of the gate dielectric may be identified as first and second gate dielectrics (e.g., around the semiconductor regions of the first and second fins respectively).

Method 500 continues with operation 510 where a sacrificial material is formed within the gate trench over the first and second gate dielectrics. The sacrificial material may be formed to the top of the gate trench and polished such that a top surface of the sacrificial material is substantially coplanar with a top surface of the spacer structures on either side of the gate trench. According to some embodiments, the sacrificial material is any suitable masking material that can be selectively removed without damaging surrounding structures, such as CHM.

Method 500 continues with operation 512 where a recess is formed through an entire thickness of the sacrificial material within the gate trench. A mask structure may be formed over the sacrificial material and an opening may be formed through the mask structure to expose a portion of the underlying sacrificial material. According to some embodiments, the opening through the mask structure is at a location where the recess is to be formed through the underlying sacrificial material. The mask structure may include any number of hard mask layers, such as any dielectric layers or carbon hard mask layers. The recess through the sacrificial material may be formed using a directional RIE process. According to some embodiments, the recess has a high height-to-width aspect ratio of at least 5:1 and extends through at least an entire thickness of the sacrificial material. According to some embodiments, portions of the first and/or second gate dielectrics are exposed within the recess along inner sidewalls of the spacer structures and at a bottom of the recess.

Method 500 continues with operation 514 where any exposed gate dielectrics are removed from the recess and a dielectric wall is formed within the recess. One or more isotropic etching processes may be performed to remove any exposed portions of the gate dielectrics within the recess. Following the removal of the first and/or second gate dielectrics within the recess, the sidewalls of the recess include sides of the sacrificial material and inner sidewalls of the spacer structures. Additionally, the bottom of the recess is a top surface of the dielectric layer extending between the subfin portions.

The dielectric wall may be formed by first depositing dielectric material to substantially fill the recess. The dielectric wall may include any suitable dielectric material, such as silicon dioxide, silicon nitride, or silicon oxynitride. As discussed above, the dielectric wall is confined within the gate trench and does not extend further than the gate spacers on either side of the gate trench.

Method 500 continues with operation 516 where the dielectric wall is recessed below a top surface of the spacer structures (and a top surface of the sacrificial material). The dielectric wall may be recessed using any suitable isotropic etching process. According to some embodiments, the dielectric material of the dielectric wall may be different from the dielectric material of the spacer structures to provide etch selectivity between the dielectric wall and the spacer structures during the recessing of the dielectric wall. According to some embodiments, the top surface of the dielectric wall is recessed to a height between the top surface of the sacrificial material and a topmost surface of the semiconductor regions of the first and second fins.

Method 500 continues with operation 518 where the sacrificial material is removed and first and second gate electrodes are formed over the respective first and second gate dielectrics. The sacrificial material may be removed using any suitable isotropic etching process or ashing process. Each of the first and second gate electrodes can represent any number of conductive layers. Each of the first and second gate electrodes may be deposited using electroplating, electroless plating, CVD, PECVD, ALD, or PVD, to name a few examples. In some embodiments, each of the first and second gate electrodes includes a metal, or a metal alloy. Example suitable metals or metal alloys include aluminum, tungsten, cobalt, molybdenum, ruthenium, titanium, tantalum, copper, and carbides and nitrides thereof. In some embodiments, the first gate electrode may include, for instance, a metal fill material (e.g., tungsten) along with one or more n-type workfunction materials (e.g., titanium aluminum carbide or tungsten) for an NMOS gate, and the second gate electrode may include, for instance, a metal fill material (e.g., tungsten) along with one or more p-type workfunction materials (e.g., titanium nitride) for a PMOS gate.

According to some embodiments, at least a portion of the first gate electrode contacts at least a portion of the second gate electrode above the dielectric wall. For example, the workfunction material of the first gate electrode may contact the workfunction material of the second gate electrode above the top surface of the dielectric wall. Portions of each of the first gate electrode and second gate electrode may contact the top surface of the dielectric wall.

### Example System

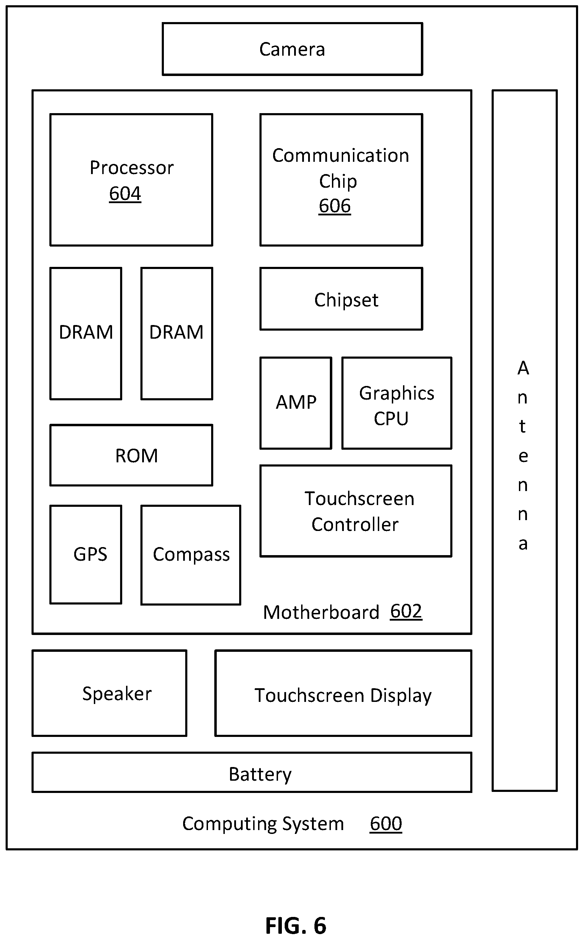

FIG. 6 is an example computing system implemented with one or more of the integrated circuit structures as disclosed herein, in accordance with some embodiments of the present disclosure. As can be seen, the computing system 600 houses a motherboard 602. The motherboard 602 may include a number of components, including, but not limited to, a processor 604 and at least one communication chip 606, each of which can be physically and electrically coupled to the motherboard 602, or otherwise integrated therein. As will be appreciated, the motherboard 602 may be, for example, any printed circuit board (PCB), whether a main board, a daughterboard mounted on a main board, or the only board of system 600, etc.

Depending on its applications, computing system 600 may include one or more other components that may or may not be physically and electrically coupled to the motherboard 602. These other components may include, but are not limited to, volatile memory (e.g., DRAM), nonvolatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 600 may include one or more integrated circuit structures or devices configured in accordance with an example embodiment, such as a module including an integrated circuit having a dielectric wall between adjacent devices where portions of the gate electrodes from the adjacent devices contact each other above the dielectric wall. In some embodiments, multiple functions can be integrated into one or more chips (e.g., for instance, note that the communication chip 606 can be part of or otherwise integrated into the processor 604).

The communication chip 606 enables wireless communications for the transfer of data to and from the computing system 600. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 606 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 600 may include a plurality of communication chips 606. For instance, a first communication chip 606 may be dedicated to shorter range wireless communications such as Wi-Fi and Bluetooth and a second communication chip 606 may be dedicated to longer range wireless communications such as GPS, EDGE, GPRS, CDMA, WiMAX, LTE, Ev-DO, and others.

The processor 604 of the computing system 600 includes an integrated circuit die packaged within the processor 604. In some embodiments, the integrated circuit die of the processor includes onboard circuitry that is implemented with one or more semiconductor devices as variously described herein. The term "processor" may refer to any device or portion of a device that processes, for instance, electronic data from registers and/or memory to transform that electronic data into other electronic data that may be stored in registers and/or memory.

The communication chip 606 also may include an integrated circuit die packaged within the communication chip 606. In accordance with some such example embodiments, the integrated circuit die of the communication chip includes one or more semiconductor devices as variously described herein. As will be appreciated in light of this disclosure, note that multistandard wireless capability may be integrated directly into the processor 604 (e.g., where functionality of any chips 606 is integrated into processor 604, rather than having separate communication chips). Further note that processor 604 may be a chip set having such wireless capability. In short, any number of processor 604 and/or communication chips 606 can be used. Likewise, any one chip or chip set can have multiple functions integrated therein.

In various implementations, the computing system 600 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device that processes data or employs one or more integrated circuit structures or devices formed using the disclosed techniques, as variously described herein.

It will be appreciated that in some embodiments, the various components of the computing system 600 may be combined or integrated in a system-on-a-chip (SoC) architecture. In some embodiments, the components may be hardware components, firmware components, software components or any suitable combination of hardware, firmware or software.

### Further Example Embodiments

The following examples pertain to further embodiments, from which numerous permutations and configurations will be apparent.

Example 1 is an integrated circuit that includes a first semiconductor device having a first semiconductor region extending in a first direction from a first source or drain region and a first gate structure extending in a second direction over the first semiconductor region, a second semiconductor device having a second semiconductor region extending in the first direction from a second source or drain region and a second gate structure extending colinearly with the first gate structure in the second direction and overthe second semiconductor region, and a dielectric wall between the first semiconductor region and the second semiconductor region and extending along a third direction through a portion of a height of the first and second gate structures. The first gate structure includes a first gate dielectric on the first semiconductor region and a first gate electrode, and the second gate structure includes a second gate dielectric on the second semiconductor region and a second gate electrode. The second gate electrode includes a different material than the first gate electrode. A portion of the first gate electrode contacts a portion of the second gate electrode above the dielectric wall.

Example 2 includes the integrated circuit of Example 1, wherein the dielectric wall comprises silicon and nitrogen.

Example 3 includes the integrated circuit of Example 1 or 2, wherein the first gate dielectric and the second gate dielectric do not extend along sidewalls of the dielectric wall.

Example 4 includes the integrated circuit of any one of Examples 1-3, further comprising spacer structures on sidewalls of the first gate structure and second gate structure and extending along the second direction with the first gate structure and second gate structure.

Example 5 includes the integrated circuit of Example 4, wherein the spacer structures comprise silicon and oxygen

Example 6 includes the integrated circuit of Example 4 or 5, wherein the dielectric wall contacts the spacer structures and does not extend beyond the spacer structures along the first direction.

Example 7 includes the integrated circuit of any one of Examples 1-6, wherein the first gate electrode comprises aluminum and the second gate electrode comprises tungsten.

Example 8 includes the integrated circuit of any one of Examples 1-7, wherein the first semiconductor device is an n-channel device and the second semiconductor device is a p-channel device.

Example 9 includes the integrated circuit of any one of Examples 1-8, wherein the first semiconductor region comprises a first plurality of semiconductor nanoribbons and the second semiconductor region comprises a second plurality of semiconductor nanoribbons.

Example 10 includes the integrated circuit of Example 9, wherein the first and second plurality of semiconductor nanoribbons comprise germanium, silicon, or a combination thereof.

Example 11 includes the integrated circuit of anyone of Examples 1-10, wherein the first gate dielectric and the second gate dielectric do not extend above a level that is coplanar with a top surface of the dielectric wall.

Example 12 includes the integrated circuit of any one of Examples 1-11, wherein the portion of the first gate electrode contacts a top surface of the dielectric wall and the portion of the second gate electrode contacts the top surface of the dielectric wall.

Example 13 includes the integrated circuit of any one of Examples 1-12, wherein the dielectric wall includes a dielectric liner along edges of the dielectric wall that includes a high-k material.

Example 14 includes the integrated circuit of any one of Examples 1-13, wherein a seam is present where the first gate electrode contacts the second gate electrode above the dielectric wall.

Example 15 is a printed circuit board comprising the integrated circuit of any one of Examples 1-14.

Example 16 is an electronic device that includes a chip package having one or more dies. At least one of the one or more dies includes a first semiconductor region extending in a first direction from a first source or drain region, a first gate structure extending in a second direction over the first semiconductor region, a second semiconductor region extending in the first direction from a second source or drain region, a second gate structure extending colinearlywith the first gate structure in the second direction and over the second semiconductor region, and a dielectric wall between the first semiconductor region and the second semiconductor region and extending along a third direction through a portion of a height of the first and second gate structures. The first gate structure includes a first gate dielectric on the first semiconductor region and a first gate electrode, and the second gate structure includes a second gate dielectric on the second semiconductor region and a second gate electrode. The second gate electrode includes a different material than the first gate electrode. A portion of the first gate electrode contacts a portion of the second gate electrode above the dielectric wall.

Example 17 includes the electronic device of Example 16, wherein the dielectric wall comprises silicon and nitrogen.

Example 18 includes the electronic device of Example 16 or 17, wherein the first gate dielectric and the second gate dielectric do not extend along sidewalls of the dielectric wall.

Example 19 includes the electronic device of any one of Examples 16-18, wherein the at least one of the one or more dies further comprises spacer structures on sidewalls of the first gate structure and second gate structure and extending along the second direction with the first gate structure and second gate structure.

Example 20 includes the electronic device of Example 19, wherein the spacer structures comprise silicon and oxygen.

Example 21 includes the electronic device of Example 19 or 20, wherein the dielectric wall contacts the spacer structures and does not extend beyond the spacer structures along the first direction.

Example 22 includes the electronic device of any one of Examples 16-21, wherein the first gate electrode comprises aluminum and the second gate electrode comprises tungsten.

Example 23 includes the electronic device of any one of Examples 16-22, wherein the first semiconductor region is part of an n-channel device, and the second semiconductor region is part of a p-channel device.

Example 24 includes the electronic device of any one of Examples 16-23, wherein the first semiconductor region comprises a first plurality of semiconductor nanoribbons and the second semiconductor region comprises a second plurality of semiconductor nanoribbons.

Example 25 includes the electronic device of Example 24, wherein the first and second plurality of semiconductor nanoribbons comprise germanium, silicon, or a combination thereof.

Example 26 includes the electronic device of any one of Examples 16-25, wherein the first gate dielectric and the second gate dielectric do not extend above a level that is coplanar with a top surface of the dielectric wall

Example 27 includes the electronic device of any one of Examples 16-26, wherein the portion of the first gate electrode contacts a top surface of the dielectric wall and the portion of the second gate electrode contacts the top surface of the dielectric wall.

Example 28 includes the electronic device of any one of Examples 16-27, further comprising a printed circuit board, wherein the chip package is coupled to the printed circuit board.

Example 29 is a method of forming an integrated circuit. The method includes forming a first fin comprising first semiconductor material and a second fin comprising second semiconductor material, the first and second fins extending above a substrate and each extending parallel to one another in a first direction, forming a sacrificial gate extending over the first and second fins in a second direction different from the first direction, forming spacer structures on sidewalls of the sacrificial gate, forming source or drain regions at ends of the first and second fins, removing the sacrificial gate, forming a gate dielectric on the first and second semiconductor material of the first and second fins and on inner sidewalls of the spacer structures, forming a sacrificial material over the first and second semiconductor material and over the gate dielectric, forming a recess through an entire thickness of the sacrificial material between the first and second semiconductor material, removing the gate dielectric exposed within the recess, forming a dielectric wall within the recess, recessing a top surface of the dielectric wall below a top surface of the spacer structures, removing the sacrificial material, forming a first gate electrode over the gate dielectric on the first semiconductor material, and forming a second gate electrode over the gate dielectric on the second semiconductor material.

Example 30 includes the method of Example 29, wherein the first gate electrode includes a different material compared to the second gate electrode.

Example 31 includes the method of Example 29 or 30, wherein forming the first gate electrode comprises forming at least a portion of the first gate electrode on a top surface of the dielectric wall.

Example 32 includes the method of Example 31, wherein forming the second gate electrode comprises forming at least a portion of the second gate electrode on a top surface of the dielectric wall.

Example 33 includes the method of any one of Examples 29-32, wherein forming the gate dielectric comprises forming a high-k dielectric layer.

Example 34 includes the method of any one of Examples 29-33, wherein forming the sacrificial material comprises forming a carbon hard mask over the first and second semiconductor material and over the gate dielectric.

Example 35 includes the method of any one of Examples 29-34, further comprising recessing a top surface of the sacrificial material below the top surface of the spacer structures, and removing the gate dielectric from above the top surface of the sacrificial material.

Example 36 is an integrated circuit that includes a first semiconductor device having a first semiconductor region extending in a first direction from a first source or drain region and a first gate structure extending in a second direction over the first semiconductor region, a second semiconductor device having a second semiconductor region extending in the first direction from a second source or drain region and a second gate structure extending colinearly with the first gate structure in the second direction and overthe second semiconductor region, and a dielectric wall between the first semiconductor region and the second semiconductor region and extending along a third direction through a portion of a height of the first and second gate structures. The first gate structure includes a first gate dielectric on the first semiconductor region and a first gate electrode, and the second gate structure includes a second gate dielectric on the second semiconductor region and a second gate electrode. The first gate dielectric and the second gate dielectric do not extend above a level that is coplanar with a top surface of the dielectric wall, and the first gate electrode and the second gate electrode extend above the level that is coplanar with the top surface of the dielectric wall.

Example 37 includes the integrated circuit of Example 36, wherein the dielectric wall comprises silicon and nitrogen.

Example 38 includes the integrated circuit of Example 36 or 37, wherein the first gate dielectric and the second gate dielectric do not extend along sidewalls of the dielectric wall.

Example 39 includes the integrated circuit of any one of Examples 36-38, further comprising spacer structures on sidewalls of the first gate structure and second gate structure and extending along the second direction with the first gate structure and second gate structure.

Example 40 includes the integrated circuit of Example 39, wherein the spacer structures comprise silicon and oxygen.

Example 41 includes the integrated circuit of Example 39 or 40, wherein the dielectric wall contacts the spacer structures and does not extend beyond the spacer structures along the first direction.

Example 42 includes the integrated circuit of any one of Examples 36-41, wherein the first gate electrode comprises aluminum and the second gate electrode comprises tungsten.

Example 43 includes the integrated circuit of any one of Examples 36-42, wherein the first semiconductor region, the first source or drain region, and the first gate structure are part of an n-channel device, and the second semiconductor region, the second source or drain region, and the second gate structure are part of a p-channel device.

Example 44 includes the integrated circuit of any one of Examples 36-43, wherein the first semiconductor region comprises a first plurality of semiconductor nanoribbons and the second semiconductor region comprises a second plurality of semiconductor nanoribbons.

Example 45 includes the integrated circuit of Example 44, wherein the first and second plurality of semiconductor nanoribbons comprise germanium, silicon, or a combination thereof.

Example 46 includes the integrated circuit of any one of Examples 36-45, wherein the first gate electrode contacts the second gate electrode above the top surface of the dielectric wall.

Example 47 includes the integrated circuit of any one of Examples 36-46, wherein a portion of the first gate electrode contacts a top surface of the dielectric wall and a portion of the second gate electrode contacts the top surface of the dielectric wall.

Example 48 is a printed circuit board comprising the integrated circuit of any one of Examples 36-47.

The foregoing description of the embodiments of the disclosure has been presented for the purposes of illustration and description. It is not intended to be exhaustive or to limit the disclosure to the precise forms disclosed. Many modifications and variations are possible in light of this disclosure. It is intended that the scope of the disclosure be limited not by this detailed description, but rather by the claims appended hereto.

The following section of the description relates to further examples. The numbered paragraphs in this section are not claims. The claims are set forth below in the later section headed "claims".
1. An integrated circuit comprising: a first semiconductor device having a first semiconductor region extending in a first direction from a first source or drain region, and a first gate structure extending in a second direction over the first semiconductor region, the first gate structure comprising a first gate dielectric on the first semiconductor region and a first gate electrode; a second semiconductor device having a second semiconductor region extending in the first direction from a second source or drain region, and a second gate structure extending colinearly with the first gate structure in the second direction and over the second semiconductor region, the second gate structure comprising a second gate dielectric on the second semiconductor region and a second gate electrode, the second gate electrode compositionally different from the first gate electrode; and a dielectric wall between the first semiconductor region and the second semiconductor region and extending along a third direction through a portion of a height of the first and second gate structures, wherein a portion of the first gate electrode contacts a portion of the second gate electrode above the dielectric wall.
2. The integrated circuit of clause 1, wherein the first gate dielectric and the second gate dielectric do not extend along sidewalls of the dielectric wall.
3. The integrated circuit of clause 1, further comprising spacer structures on sidewalls of the first gate structure and second gate structure and extending along the second direction with the first gate structure and second gate structure.
4. The integrated circuit of clause 3, wherein the dielectric wall contacts the spacer structures and does not extend beyond the spacer structures along the first direction.
5. The integrated circuit of clause 1, wherein the first semiconductor device is an n-channel device and the second semiconductor device is a p-channel device.
6. The integrated circuit of clause 1, wherein the first semiconductor region comprises a first plurality of semiconductor nanoribbons and the second semiconductor region comprises a second plurality of semiconductor nanoribbons.
7. The integrated circuit of clause 1, wherein the first gate dielectric and the second gate dielectric do not extend above a level that is coplanar with a top surface of the dielectric wall.
8. The integrated circuit of clause 1, wherein the portion of the first gate electrode contacts a top surface of the dielectric wall and the portion of the second gate electrode contacts the top surface of the dielectric wall.
9. The integrated circuit of clause 1, wherein a seam is present where the first gate electrode contacts the second gate electrode above the dielectric wall.
10. A printed circuit board comprising the integrated circuit of clause 1.
11. An electronic device, comprising: a chip package comprising one or more dies, at least one of the one or more dies comprising a first semiconductor region extending in a first direction from a first source or drain region; a first gate structure extending in a second direction over the first semiconductor region, the first gate structure comprising a first gate dielectric on the first semiconductor region and a first gate electrode; a second semiconductor region extending in the first direction from a second source or drain region; a second gate structure extending colinearlywith the first gate structure in the second direction and over the second semiconductor region, the second gate structure comprising a second gate dielectric on the second semiconductor region and a second gate electrode, the second gate electrode comprising a different material than the first gate electrode; and a dielectric wall between the first semiconductor region and the second semiconductor region and extending along a third direction through a portion of a height of the first and second gate structures, wherein a portion of the first gate electrode contacts a portion of the second gate electrode above the dielectric wall.
12. The electronic device of clause 11, wherein the at least one of the one or more dies further comprises spacer structures on sidewalls of the first gate structure and second gate structure and extending along the second direction with the first gate structure and second gate structure.
13. The electronic device of clause 12, wherein the dielectric wall contacts the spacer structures and does not extend beyond the spacer structures along the first direction.
14. The electronic device of clause 11, wherein the first gate dielectric and the second gate dielectric do not extend above a level that is coplanar with a top surface of the dielectric wall.
15. The electronic device of clause 11, wherein the portion of the first gate electrode contacts a top surface of the dielectric wall and the portion of the second gate electrode contacts the top surface of the dielectric wall.
16. An integrated circuit comprising: a first semiconductor region extending in a first direction from a first source or drain region; a first gate structure extending in a second direction over the first semiconductor region, the first gate structure comprising a first gate dielectric on the first semiconductor region and a first gate electrode around the first gate dielectric; a second semiconductor region extending in the first direction from a second source or drain region; a second gate structure extending colinearlywith the first gate structure in the second direction and over the second semiconductor region, the second gate structure comprising a second gate dielectric on the second semiconductor region and a second gate electrode around the second gate dielectric; and a dielectric wall between the first semiconductor region and the second semiconductor region and extending along a third direction through a portion of a height of the first and second gate structures, wherein the first gate dielectric and the second gate dielectric do not extend above a top surface of the dielectric wall and wherein the first gate electrode and the second gate electrode extend above the top surface of the dielectric wall.
17. The integrated circuit of clause 16, wherein the first semiconductor region, the first source or drain region, and the first gate structure are part of an n-channel device, and the second semiconductor region, the second source or drain region, and the second gate structure are part of a p-channel device.
18. The integrated circuit of clause 16, wherein the first semiconductor region comprises a first plurality of semiconductor nanoribbons and the second semiconductor region comprises a second plurality of semiconductor nanoribbons.
19. The integrated circuit of clause 16, wherein the first gate electrode contacts the second gate electrode above the top surface of the dielectric wall.
20. The integrated circuit of clause 16, wherein a portion of the first gate electrode contacts a top surface of the dielectric wall and a portion of the second gate electrode contacts the top surface of the dielectric wall.

## Claims

1. An integrated circuit comprising:
a first semiconductor device having a first semiconductor region extending in a first direction from a first source or drain region, and a first gate structure extending in a second direction over the first semiconductor region, the first gate structure comprising a first gate dielectric on the first semiconductor region and a first gate electrode;
a second semiconductor device having a second semiconductor region extending in the first direction from a second source or drain region, and a second gate structure extending colinearlywith the first gate structure in the second direction and over the second semiconductor region, the second gate structure comprising a second gate dielectric on the second semiconductor region and a second gate electrode, the second gate electrode compositionally different from the first gate electrode; and
a dielectric wall between the first semiconductor region and the second semiconductor region and extending along a third direction through a portion of a height of the first and second gate structures, wherein a portion of the first gate electrode contacts a portion of the second gate electrode above the dielectric wall.

2. The integrated circuit of claim 1, wherein the dielectric wall comprises silicon and nitrogen.

3. The integrated circuit of claim 1 or 2, wherein the first gate dielectric and the second gate dielectric do not extend along sidewalls of the dielectric wall.

4. The integrated circuit of any one of claims 1 through 3, further comprising spacer structures on sidewalls of the first gate structure and second gate structure and extending along the second direction with the first gate structure and second gate structure.

5. The integrated circuit of claim 4, wherein the spacer structures comprise silicon and oxygen.

6. The integrated circuit of claim 4 or 5, wherein the dielectric wall contacts the spacer structures and does not extend beyond the spacer structures along the first direction.

7. The integrated circuit of any one of claims 1 through 6, wherein the first gate electrode comprises aluminum and the second gate electrode comprises tungsten.

8. The integrated circuit of any one of claims 1 through 7, wherein the first semiconductor device is an n-channel device and the second semiconductor device is a p-channel device.

9. The integrated circuit of any one of claims 1 through 8, wherein the first semiconductor region comprises a first plurality of semiconductor nanoribbons and the second semiconductor region comprises a second plurality of semiconductor nanoribbons.

10. The integrated circuit of claim 9, wherein the first and second plurality of semiconductor nanoribbons comprise germanium, silicon, or a combination thereof.

11. The integrated circuit of any one of claims 1 through 10, wherein the first gate dielectric and the second gate dielectric do not extend above a level that is coplanar with a top surface of the dielectric wall.

12. The integrated circuit of any one of claims 1 through 11, wherein the portion of the first gate electrode contacts a top surface of the dielectric wall and the portion of the second gate electrode contacts the top surface of the dielectric wall.

13. The integrated circuit of any one of claims 1 through 12, wherein the dielectric wall includes a dielectric liner along edges of the dielectric wall that includes a high-k material.

14. The integrated circuit of any one of claims 1 through 13, wherein a seam is present where the first gate electrode contacts the second gate electrode above the dielectric wall.

15. A printed circuit board comprising the integrated circuit of any one of claims 1 through 14.
